# EUROPÄISCHE PATENTSCHRIFT

(11) **EP 2 170 026 B1**
(45) Veröffentlichungstag und Bekanntmachung des Hinweises auf die Patenterteilung: **26.10.2011**
(21) Anmeldenummer: 09014389.2
(22) Anmeldetag: 11.04.2003
(51) Int. Cl.: H05K 3/28, H05K 3/46

(54) **Metall-Keramik-Substrat für elektrische Schaltkreise- oder Module, Verfahren zum Herstellen eines solchen Substrates sowie Modul mit einem solchen Substrat**
Metal ceramic substrate for electric components or modules, method for producing such a substrate and module with such a substrate
Substrat en céramique et métal pour circuits ou modules électriques, procédé de fabrication d'un tel substrat ainsi que module doté d'un tel substrat

(30) Priorität: 20.06.2002 DE 10227658
(43) Veröffentlichungstag der Anmeldung: 31.03.2010
(62) Teilanmeldung aus: 03727202.8
(73) Patentinhaber: Curamik Electronics GmbH, 92676 Eschenbach (DE)
(72) Erfinder: Schulz-Harder, Jürgen, Dr., 91207 Lauf (DE); Haberl, Peter, 92242 Hirschau (DE)
(74) Vertreter: Graf, Helmut

(56) Entgegenhaltungen:
- JP-A- 1 057 795

## Beschreibung

Die Erfindung bezieht sich auf eine Metall-Keramik-Substrat gemäß Oberbegriff Patentanspruch 1.

Metall-Keramik-Substrate, auch Kupfer-Keramik-Substrate für elektrische Schaltkreise, insbesondere für Halbleiter-Leistungs-Schaltkreise oder -module sind in verschiedensten Ausführungen bekannt. Bekannt ist es dabei speziell auch, die zum Herstellen von Leiterbahnen, Anschlüssen usw. benötigte Metallisierung auf einer Keramik, z.B. auf einer Aluminium-Oxid-Keramik mit Hilfe des sogenannten ,DCB-Verfahrens" (Direct Copper-Bond-Technology) herzustellen, und zwar unter Verwendung von die Metallisierung bildenden Metall- bzw. Kupferfolien oder Metall- bzw. Kupferblechen, die an ihren Oberflächenseiten eine Schicht oder einen Überzug (Aufschmelzschicht) aus einer chemischen Verbindung aus dem Metall und einem reaktiven Gas , bevorzugt Sauerstoff aufweisen. Bei diesem beispielsweise in der US-PS 37 44 120 oder in der DE-PS 23 19 854 beschriebenen Verfahren bildet diese Schicht oder dieser Überzug (Aufschmelzschicht) ein Eutektikum mit einer Schmelztemperatur unter der Schmelztemperatur des Metalls (z.B. Kupfers), so dass durch Auflegen der Folle auf die Keramik und durch Erhitzen sämtlicher Schichten diese miteinander verbunden werden können, und zwar durch Aufschmelzen des Metalls bzw. Kupfers im wesentlichen nur im Bereich der Aufschmelzschicht bzw. Oxidschicht.

Dieses DCB-Verfahren weist dann z.B. folgende Verfahrensschritte auf:
Oxidieren einer Kupferfolie derart, dass sich eine gleichmäßige Kupferoxidschicht ergibt;
Auflegen des Kupferfolie auf die Keramikschicht;
- Erhitzen des Verbundes auf eine Prozesstemperatur zwischen etwa 1025 bis 1083 °C, z.B. auf ca. 1071 °C;
Abkühlen auf Raumtemperatur.

Die Herstellung von elektrischen Schaltkreisen oder Modulen, insbesondere die Fertigung von Leistungs-Schaltkreisen oder -modulen mit einem Leistungsteil und einem Ansteuer- oder Treibertell erfolgt bisher so, dass als Substrat oder Leiterplatte für den Leistungsteil ein Metall-Keramik-Substrat verwendet wird und das der auf einer eigenständigen Leiterplatte mit seinen Bauelementen fertigbestückte Ansteuer- oder Treiberschaltkrels dann in einer weiteren Ebene über dem Leistungsteil oder aber neben diesem auf dem'Metall-Keramik-Substrat mit geeigneten Mitteln montiert wird.

Nachteilig ist hierbei u.a. eine aufwendige Herstellung, da das Leistungsteil und die Ansteuer- oder Trelberstufe gesondert gefertigt und dann in der Fertigung zusammengeführt und miteinander verbunden werden müssen. Insbesondere ist mit dieser bekannten.Technik eine den Gesichtspunkten einer rationellen Fertigung gerecht werdenden Herstellung des gesamten Moduls (Leistungsteil + Ansteuer- und Treiberstufe) im Mehrfachnutzen nicht möglich.

Bekannt ist weiterhin ein Substrat für elektrische Schaltkreise oder Module mit wenigstens einer Isolierschicht und mit wenigstens einer auf einer Oberflächenseite der lsollerschicht unter Verwendung des Dickfilmverfahrens aufgebrachten strukturierten Metallschicht, die Leiterbahnen und Kontaktflächen bilden (JP-01-057795). Auf die strukturierte Metallschicht ist ein Lötstopauftrag aus einem glashaltigen Materlal aufgebracht.

Aufgabe der Erfindung ist es, ein Metall-Keramik-Substrat aufzuzeigen, welches eine besonders rationale Fertigung von Schaltkreisen, insbesondere Halbleiterschaltkrelsen und dabei speziell auch von Leistungsschaltkreisen mit zugehöriger Ansteuer- und Treiberstufe gestattet. Zur Lösung dieser Aufgabe ist ein Metall-Keramik-Substrat entsprechend dem Patentanspruch 1 ausgebildet.

Weiterbildungen der Erfindungsind Gegenstand der Unteransprüche.

Wesentliche Vorteile der Erfindung lassen sich, wie folgt zusammenfassen:
- Vereinfachte Fertigung sowohl des Leistungsbereichs, als auch des Ansteuer- und Treiberbereichs;
   genaue Positionierung des Leistungsbereichs und des Ansteuer- oder Treiberbereichs bzw. der dortigen, durch Strukturierung gebildeten Bereiche (Leiterbahnen, Kontaktflächen, Montageflächen usw.) und hierdurch auch Vereinfachung bei der Bestückung mit den Bauelementen;
- Bestückung des Leistungsbereichs und des Ansteuer- und Treiberbereichs in einem Arbeitsgang möglich;
- da keine organischen Substratmaterialen verwendet sind, sind hohe Löttemperaturen, beispielsweise Löttemperaturen bis zu 400°C beim Bestücken mit Bauelementen möglich, es können insbesondere auch bleifreie Lötmaterialien verwenden werden;
ein Aufbringen einer Löt- oder Klebepaste beim Bestücken des Substrates ist wesentlich vereinfacht, da sich die Ebene der zu bestückenden Oberfläche des Leistungsteils und die Ebene der zu bestückenden Oberfläche des Ansteuer- oder Treiberteils im Niveau nur geringfügig unterscheiden;
der Auftrag von Lötpasten oder Klebestoffen für die Bestücken sowohl des Leistungsteils als auch des Ansteuer- oder Treiberteils ist in einem Arbeitsgang möglich;
- vereinfachte Verdrahtung zwischen dem Leistungsteil und dem Ansteuer- und Treiberteil durch Ultraschall-Bonding;
verbesserte Kühlung der Ansteuer- oder Treiberstufe durch verbesserte Anbindung an ein Kühlsystem;
durch einfach realisierbare Cross-Over-Technik ist eine hohe Komplexität der Schaltung der Ansteuer- und Treiberstufe möglich.

Die Erfindung wird im folgenden anhand der Figuren an Ausführungsbeispielen näher erläutert. Es zeigen:
- Fig. 1: und 2 in vereinfachter Schnittdarstellung Halbleitermodule nach dem Stand der Technik;
- Fig. 3: in einer schematischen Schnittdarstellung den Schichtaufbau einer Ausführungsform des Metall-Keramik-Substrat gemäß der Erfindung;
- Fig. 4: in Schnittdarstellung ein Metall-Keramik-Substrat der Fig. 3 strukturiert mit einem Bereich zur Aufnahme von wenigstens einem Leistungs- Halbleiterbauelement und einem weiteren Bereich für einen Ansteuerschaltkreis;
- Fig. 5: und 6 jeweils in einer schematischen Schnittdarstellung den Schichtaufbau weiterer Ausführungsformen des Metall-Keramik-Substrat gemäß der Erfindung;
- Fig. 7: in Schnittdarstellung ein Halbleitermodul hergestellt unter Verwendung des strukturierten Metall-Keramik-Substrats der Fig. 4;
- Fig. 8: das Halbleitermodul der Figur 7, jedoch zusammen mit einer zusätzlichen Grundplatte;
- Fig. 9: in Teildarstellung und im Schnitt ein Halbleitermodul hergestellt unter Verwendung des strukturierten Metall-Keramik-Substrats der Fig. 5;
- Fig. 10: in vereinfachter Darstellung und in Draufsicht eine weitere mögliche Ausführungsform des erfindungsgemäßen Metall-Keramik-Substrates.

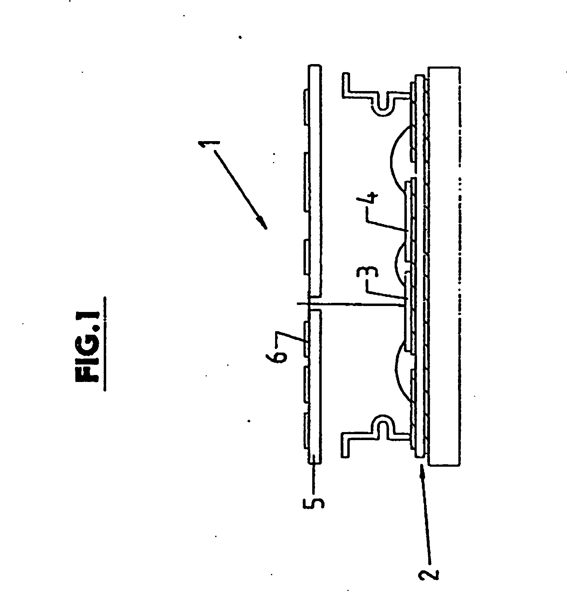

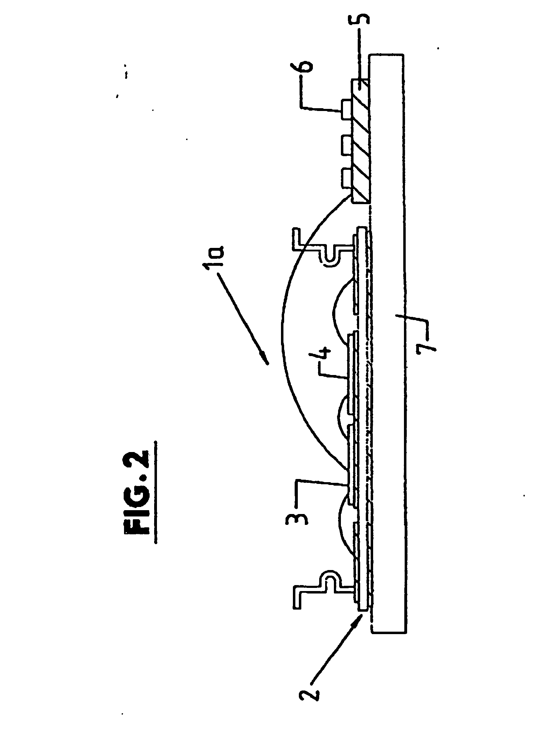

Die Figur 1 zeigt in vereinfachter Darstellung und im Schnitt ein Halbleitermodul 1, wie es aus dem Stand der Technik bekannt ist. Dieses Halbleitermodul besteht u.a. aus einem Kupfer-Keramik-Substrat 2 mit Halbleiter-Leistungsbauelementen 3 und 4, beispielsweise Transistoren oder Thyristoren zum Steuern eines elektrischen Antriebs usw., sowie aus einer Leiterplatine oder -platte 5 aus organischem Material (Kunststoff), die mit Bauelementen 6 bestückt ist und eine die Leistungsbauelemente 3 und 4 ansteuernde Treiberstufe- und/oder Regelstufe bildet. Die Leiterplatine oder - platte 5 mit den Bauelementen 6 ist oberhalb des Substrates 2 angeordnet. Die Figur 2 zeigt ein Halbleitermodul 1a, wie es ebenfalls aus dem Stand der Technik bekannt ist. Auf einer gemeinsamen Grundplatte 7 ist das Substrat 2 mit den Leistungsbauelementen 3 und 4 vorgesehen, und zwar zusammen mit der die Bauelemente 6 aufweisenden Leiterplatte 5 aus organischem Material (Kunststoff), die seitlich vom Substrat 2 auf einem Träger 7 angeordnet ist.

Der bekannte Aufbau hat den Nachteil einer aufwendigen Verdrahtung und sich hieraus ergebender hoher Montagekosten. Darüber hinaus ist es erforderlich, dass beide Teile des Moduls 1 bzw. 1a, nämlich das Substrat 2 und der die Leiterplatte 5 mit den Bauelementen 6 aufweisende Teil gesondert gefertigt, in der Fertigung zusammengeführt und mechanisch verbunden werden.

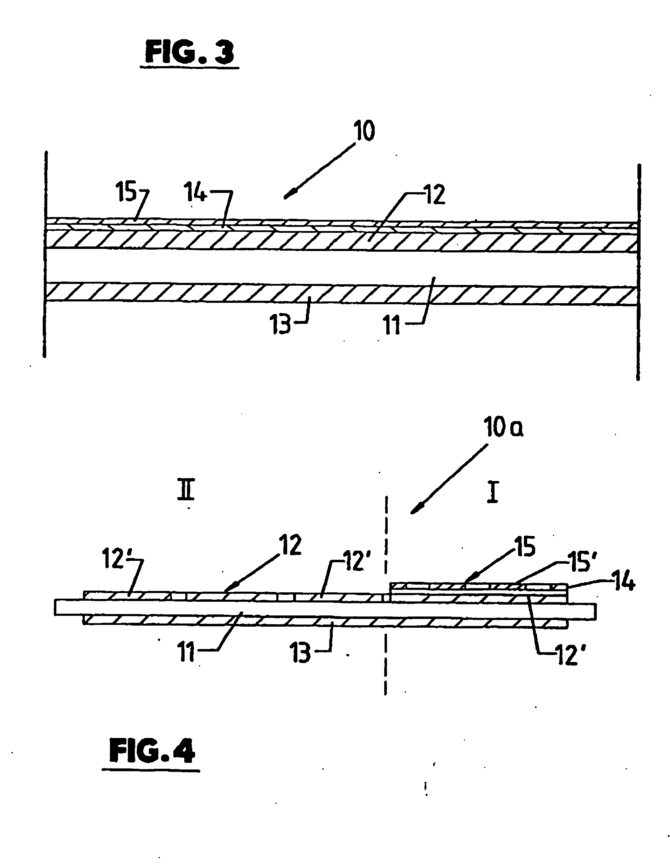

Die Figuren 3 zeigt den generellen Schichtaufbau eines Metall-Keramik-Substrates 10 gemäß der Erfindung. Dieses Substrat besteht aus der Keramikschicht 11, die beidseitig mit jeweils einer Metallschicht 12 bzw. 13 eines ersten Typs versehen ist. Bei der dargestellten Ausführungsform sind die Metallschichten 12 und 13 von Metallfolien gebildet, die mit Hilfe des Direct-Bonding-Verfahrens ganzflächig auf die Keramikschicht 11 aufgebracht sind.

Auf die in der Figur 3 obere Metallschicht 12 ist eine Schicht 14 aus einem Dielektrikum bzw. aus einem isolierenden Material aufgebracht, und zwar mit einer Dicke, die wesentlich kleiner ist als die Dicke der Metallschichten 12 und 13. Die Schicht 14 besteht beispielsweise aus einem glashaltigen Material, welches durch Erhitzen oder Einbrennen auf die Metallschicht 12 aufgebracht ist. Auf der isolierenden Schicht 14 ist eine weitere Metallschicht 15 eines zweiten Typs vorgesehen. Die Metallschicht 15 ist durch Aufbringen einer Leitpaste und durch Einbrennen dieser Leitpaste hergestellt, und zwar wiederum mit einer Dicke, die wesentlich kleiner ist als die Dicke der Metallschichten 12 und 13.

Die Dicke der Keramikschicht 11 beträgt beispielsweise 0,2 bis 2 mm. Die Metallschichten 12 und 13 besitzen beispielsweise eine Dicke im Bereich zwischen 0,1 bis 0,9 mm. Die Isolierschicht 14 besitzt eine Dicke im Bereich zwischen 0,015 bis 0,15 mm. Die Dicke der Metallschicht 15 liegt im Bereich zwischen etwa 0,015 bis 0,15 mm.

Bei der dargestellten Ausführungsform besitzen die Metallschichten 12 und 13 die selbe Dicke und bestehen aus Kupfer. Die Keramik der Keramikschicht 11 ist beispielsweise eine Aluminiumoxid-Keramik.

Die Herstellung des Mehrschicht-Metall-Keramik-Substrates erfolgt z.B. in einem Verfahren mit folgenden Verfahrensschritten:
a) Zur Bildung der Metallschichten 12 und 13 werden mittels des DCB-Prozesses wenigstens zwei an ihren Oberflächenseiten oxidierte Zuschnitte einer Kupferfolie jeweils auf eine Oberflächenseite der Keramikschicht 11 aufgebracht. Vor dem Aufbringen werden die Kupferfolienzuschnitte vorzugsweise in einem vorausgehenden Verfahrensschritt in einer Schutzgasatmosphäre, beispielsweise in einer Stickstoffatmosphäre getempert, und zwar zur Reduzierung der Härte des Kupfermaterials.
b) Nach dem Abkühlen wird auf die Metallschicht 12 beispielsweise durch Aufdrucken oder mit einem anderen, geeigneten Verfahren eine die spätere Isolierschicht 14 bildende Schicht aus einer glashaltigen Paste aufgebracht.
c) Die Paste wird getrocknet und dann bei einer Temperatur, die unter der Temperatur des DCB-Prozesses liegt, d.h. beispielsweise bei einer Temperatur im Bereich zwischen 750 und 1030°C eingebrannt, so dass die Paste dann die auf der Metallschicht 12 haftende Isolierschicht 14 bildet.
d) Nach einem erneuten Abkühlen wird auf die Isolierschicht 15, beispielsweise wiederum durch Aufdrucken oder mit einem anderen geeigneten Verfahren, eine metallische Bestandteile enthaltende Leitpaste aufgebracht,
e) die Leitpaste (Dickfilm) wird dann bei einer Temperatur im Bereich zwischen 750 bis 1030°C eingebrannt.

Um für die Isolierschicht 14 und/oder die Metallschicht 15 eine größere Dicke zu erreichen, können die Verfahrensschritte b) und c) und/oder d) und e) mehrfach wiederholt werden. Grundsätzlich besteht auch die Möglichkeit, auf die Metallschicht 15 noch wenigstens eine weitere Schichtfolge zumindest bestehend aus der Isolierschicht 14 und einer weiteren Metallschicht 15 aufzubringen. Das Oxidieren der Kupferfolienzuschnitte kann vor und/oder nach dem Tempern und auch während des DCB-Prozesses erfolgen.

Für die Isolierschicht 14 wird bevorzugt eine Paste verwendet, die nach dem Einbrennen eine Schicht 14 liefert, welche einen höheren Schmelzpunkt aufweist als die Paste vor dem Einbrennen, so dass ein mehrfaches Aufbringen und Einbrennen der glashaltigen Paste zur Erzielung einer größeren Schichtdicke möglich ist. Gleiches gilt auch für Paste, die für die Metallschicht 15 verwendet wird. Zum Herstellen der Isolierschicht 14 eignet sich beispielsweise eine von der Firma Du Pont Electronics unter der Bezeichnung "Dielectric Composition 4575D" angebotene Paste. Für die Herstellung der Metallschicht 15 eignet sich beispielsweise eine ebenfalls von der Firma Du Pont Electronics unter der Bezeichnung "Copper- Conductor Composition 9922" angebotene Paste.

Vorstehend wurde zur Erläuterung des generellen Schichtaufbaus sowie zur Erläuterung möglicher Herstellungsverfahren davon ausgegangen, dass die Schichtfolge bestehend aus der Isolierschicht 14 und der Metallschicht 15 die Metallschicht 12 auf ihrer gesamten Oberfläche überdeckt. In praktischen Anwendungen des erfindungsgemäßen Substrates erfolgt aber das Aufbringen der Schichtfolge(n) 14/15 in der Weise, dass diese Schichtfolge(n) nur einen Teil der Oberfläche der Metallschicht 12 einnimmt oder einnehmen, wie dies in der Figur 4 im dortigen Abschnitt 1 des dortigen Metall-Keramik-Substrat 10a angedeutet ist, während im Abschnitt II die Oberfläche der Metallschicht 12 frei liegt. Hierdurch besteht die Möglichkeit, die Metallschicht 12 mit geeigneten Technik, beispielsweise mit Ätz-Maskierungs-Techniken zu strukturieren, und zwar zur Bildung von Leiterbahnen, Kontaktflächen usw., wie dies in der Figur 4 mit 12' angedeutet ist. In gleicher Weise ist auch die Metallschicht 15 zur Bildung von Leiterbahnen, Kontaktflächen, Anschlüssen usw. strukturiert, wie dies mit 15' angedeutet ist. Die Strukturierung der Metallschicht 15 ist dabei sehr viel feiner ausgeführt als die Strukturierung der Metallschicht 12, was allein schon wegen der wesentlichen geringeren Dicke der Metallschicht 15 möglich ist.

Die Strukturierung der Metallschicht 15 erfolgt beispielsweise ebenfalls mit einer Ätz- und Maskierungstechnik und/oder aber dadurch, dass diese Strukturierung bereits durch entsprechendes strukturiertes Aufbringen der die Metallschicht 15 bildenden Leitpaste erreicht ist, beispielsweise durch strukturiertes Aufdrucken.

Wird die Metallschicht 15 mit einem Maskierungs-Ätz-Verfahren strukturiert, und zwar nach dem Strukturieren der Metallschicht 12, ist es grundsätzlich nicht erforderlich, die strukturierte Metallschicht 12 bzw. deren Bereiche 12' durch eine Maske aus Ätzresist abzudecken. Da die Schichtdicke der Metallschicht 15 sehr viel kleiner ist als die Schichtdicke der Metallschicht 12, hat beim Strukturieren der Metallschicht 15 ein zusätzliches Einwirken des Ätzmittels auf die Metallschicht 12 keine Wirkung. Allenfalls wird eine Abrundung von Kanten der strukturierten Bereiche 12' bewirkt und damit in vorteilhafter Weise durch das Vermeiden von scharfen Kanten die elektrische Spannungsfestigkeit erhöht.

Durch Verwendung der Direct-Bonding-Technik zum Aufbringen der Metallschichten 12 und 13 ist eine hohe Haftfestigkeit (Peelfestigkeit) größer als 30N/cm für diese Metallschichten an der Keramikschicht 11 erreicht. Diese hohe Haftfestigkeit ist wesentlich, um ein Abheben oder Lösen der Metallschicht 12 zu verhindern, insbesondere am Rand der Metallschicht 12 oder der strukturierten Bereiche 12', und zwar ein Abheben oder Lösen bedingt durch thermische Spannungen nach dem Abkühlen der Isolierschicht 14 und/oder der Metallschicht 15, jeweils nach dem Einbrennen.

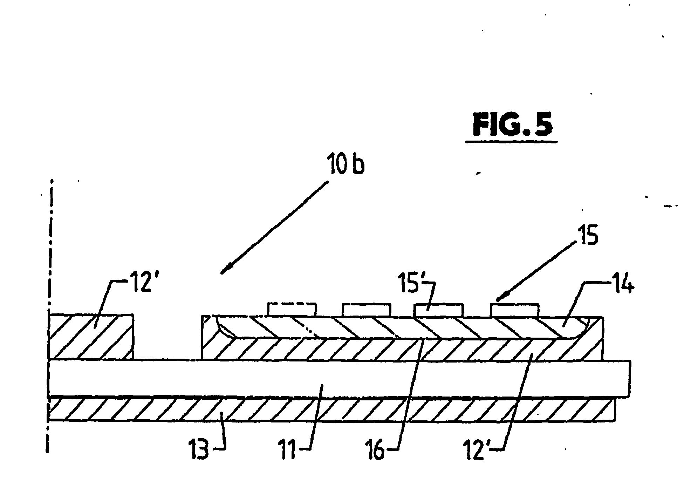

Die Figur 5 zeigt als weitere mögliche Ausführungsform ein Metall-Keramik-Substrat 10b, welches sich von dem Substrat 10a im wesentlichen nur dadurch unterscheidet, dass die Isolierschicht 14 in einer wannenartigen Vertiefung 16 eines strukturierten Bereichs 12' der Metallschicht 12 angeordnet ist. Abweichend von dem vorstehend beschriebenen Verfahren zum Herstellen des Metall-Keramik-Substrates 10 erfolgt die Herstellung des Substrates 10b beispielsweise so, dass nach dem Aufbringen der Metallschichten 12 und 13 mittels der Direct-Bondung-Techik (Verfahrensschritt a)) anschließend durch einen oder mehrere Verfahrensschritte, beispielsweise durch ein Maskierungs- und Ätzverfahren zunächst die muldenartige Vertiefung 16 in der Metallschicht 12 gebildet wird, und zwar ohne eine weitere Strukturierung der Metallschicht 12. Erst dann daran wird mit den weiteren Verfahrensschritten b) und c), die wiederum mehrfach ausgeführt werden können, die Isolierschicht 14 in der Vertiefung 16 gebildet und auf diese dann mit den Verfahrensschritten d) und e), die ebenfalls mehrfach ausgeführt werden können, die Metallschicht 15 aufgebracht. In weiteren Verfahrensschritten erfolgt dann zur Bildung der strukturierten Bereiche 12' und 15' die Strukturierung der Metallschichten 12 und 15, beispielsweise wiederum mit Ätz- und Maskierungstechniken. Ein strukturierter Bereich 12' weist dann die Vertiefung 16 mit der Isolierschicht 14 auf. Die übrigen strukturierten Bereiche 12' bilden z.B. Kontaktflächen, Leiterbahnen usw. für das oder die HalbleiterLeistungsbauelemente bilden.

Die Metallschicht 15 ist bei der dargestellten Ausführungsform so strukturiert, dass sämtliche Bereiche 15' durch die Isolierschicht 14 von dem die Vertiefung 16 aufweisenden Bereich 12' elektrisch getrennt sind. Die Bereiche 15' bilden zumindest teilweise Leiterbahnen, Kontaktflächen usw. für die den Ansteuerschaltkreis mit geringerer Leistung.

Selbstverständlich sind zur Herstellung des Metall-Keramik-Substrates 10b auch andere Verfahren denkbar, z.B. solche, bei denen bereits beim Einbringen der Vertiefung 16 oder aber in einem vorausgehenden oder anschließenden Verfahrensschritt die Strukturierung der Metallschicht 12 zur Bildung der Bereiche 12' erfolgt und/oder die strukturierten Bereiche 15' der Metallschicht wiederum durch strukturiertes Aufbringen der diese Metallschicht bildenden Paste erfolgt.

Das Metall-Keramik-Substrat 10b mit der Vertiefung 16 hat den Vorteil, dass das Aufbringen der Isolierschicht 14 vereinfacht ist und darüber hinaus die Oberseite dieser Isolierschicht in einer Ebene mit der Oberseite der Metallschicht 12 bzw. der Bereiche 12' liegt, was für das Herstellungsverfahren, insbesondere auch für die weitere Verarbeitung dieses Substrates von besonderem Vorteil sein kann.

Weiterhin ist es durch die Ausbildung möglich, die Isolierschicht 14 so aufzubringen, dass die Oberseite des für die Vertiefung 16 aufweisenden Bereichs 12' von dem die Isolierschicht 14 bildenden Material zuverlässig frei gehalten ist, so dass sich außerhalb der Isolierschicht 14 an der Oberseite des die Vertiefung 16 aufweisenden Bereichs 12' eine reine metallische Fläche ergibt, auf der weitere Elemente, beispielsweise auch ein Gehäuse, z.B. durch Löten oder auf andere Weise hermetisch dicht befestigt werden kann, und zwar ohne Störungen durch Reste des die Isolierschicht 14 bildenden Materials.

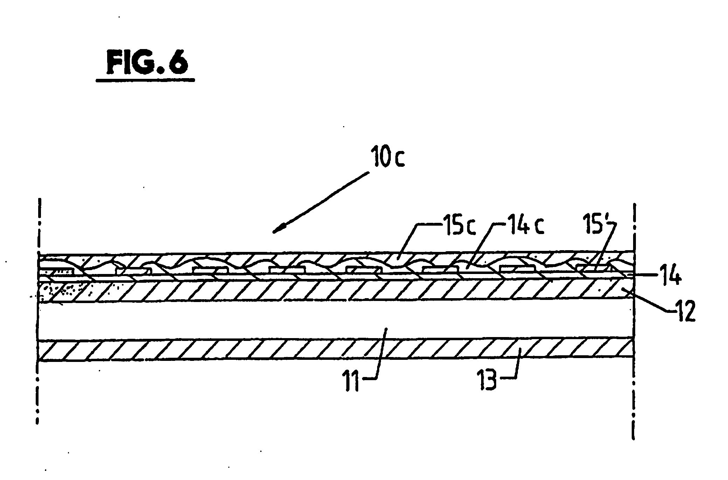

Die Figur 6 zeigt im Teilschnitt als weitere mögliche Ausführung den Schichtaufbau eines Metall-Keramik-Substrates 10c, welches sich von dem Substrat 10 **dadurch unterscheidet, dass** nach dem Strukturieren der Metallschicht 15 auf diese bzw. auf deren strukturierte Bereiche 15' eine weitere Isolierschicht 14 aufgebracht wird, und zwar wiederum durch Auftragen und durch Einbrennen der glashaltigen Paste nach dem Trocknen.

Beim Aufbringen der weiteren Isolierschicht 14c werden in dieser Öffnungen oder Fenster vorgesehen, und zwar über einigen der strukturierten Bereiche 15', so dass dann beim Aufbringen der weiteren Metallschicht 15c, die der Metallschicht 15 entspricht und die wiederum durch Auftragen und Einbrennen der Leitpaste erzeugt wird, eine elektrische Verbindung zwischen den strukturierten Bereichen 15' und der weiteren, darüber liegenden Metallschicht 15c bestehen. Hierbei ist es selbstverständlich auch möglich, auf der Metallschicht 15c, vorzugsweise nach der Strukturierung dieser Metallschicht weitere Schichtfolgen bestehend aus wenigstens einer Isolierschicht entsprechend der Isolierschicht 14 oder 14c und wenigstens einer Metallschicht entsprechend der Metallschicht 15 bzw. 15c aufzubringen. Mit dem in der Figur 6 dargestellten Aufbau sind somit sehr komplexe Metall-Keramik-Substrate oder Substratbereiche für Schaltkreise mit reduzierter Leistung, insbesondere auch für Ansteuer- und Regelschaltkreise für elektrische Leistungsbauelemente realisierbar, und zwar bei kleinem Bauvolumen.

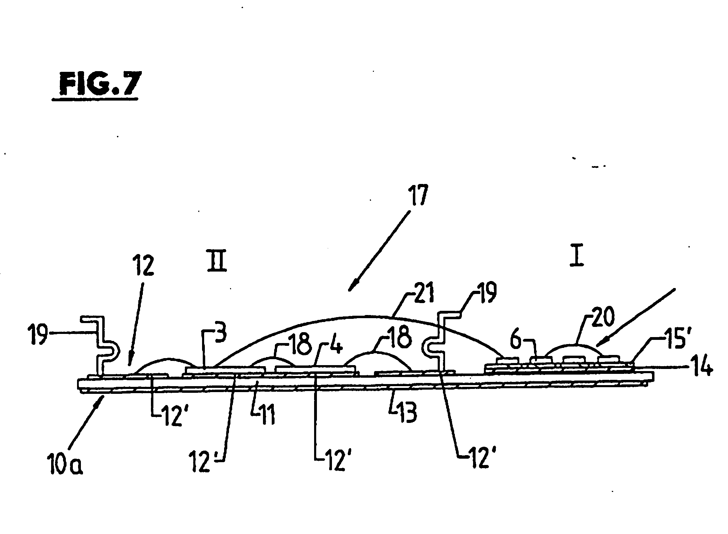

Die Figur 7 zeigt in vereinfachter Darstellung und im Schnitt ein Halbleiterleistungsmodul 17, welches unter Verwendung des Metall-Keramik-Substrates 10a hergestellt ist. Auf dem Abschnitt II des Substrates 10a bzw. auf zwei dortigen, strukturierten Bereichen 12' ist jeweils ein Halbleiterleistungsbauelement 3 bzw. 4 vorgesehen. Über interne elektrische Verbindungen 18 (z.B. Drahtbonds) sind die Bauelemente 3 und 4 u.a. mit weiteren Bereichen 12' verbunden, die als Kontaktflächen dienen und an denen äußere Leistungsanschlüsse 19 vorgesehen ist. Die strukturierten Bereiche 15' bilden die Leiterbahnen, Kontaktflächen usw. für den Ansteuerschaltkreis oder Treiber zum Ansteuern der die Bauelemente 3 und 4 aufweisenden Leistungsstufe. Auf den Bereichen 15' sind die entsprechenden Bauelemente 6 dieser Treiberstufe vorgesehen. Weitere Bereiche 15' bilden Kontaktflächen, die über interne Anschlüsse 20 mit den Bauelementen, Leiterbahnen usw. verbunden sind und die dann beispielsweise auch äußere Steueranschlüsse des Moduls 17 bilden, sowie auch Kontaktflächen, die über interne Verbindungen 21 mit dem Leistungsteil II verbunden sind.

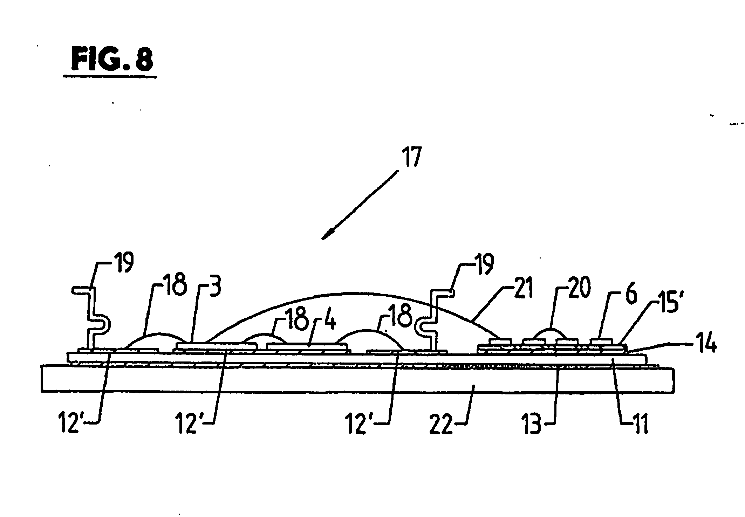

Die Figur 8 zeigt nochmals das Leistungsmodul 17, zusammen mit einer Grundplatte 22 aus einem Material, welches eine hohe Wärmeleitfähigkeit sowie hohe mechanische Stabilität aufweist. Insbesondere bei großen, komplexen Modulen ist diese Grundplatte 22 zur Erhöhung der mechanischen und/oder thermischen Stabilität, auch zur Vermeidung von Verformungen des Metall-Keramik-Substrates 10a bei Temperaturschwankungen usw. zweckmäßig.

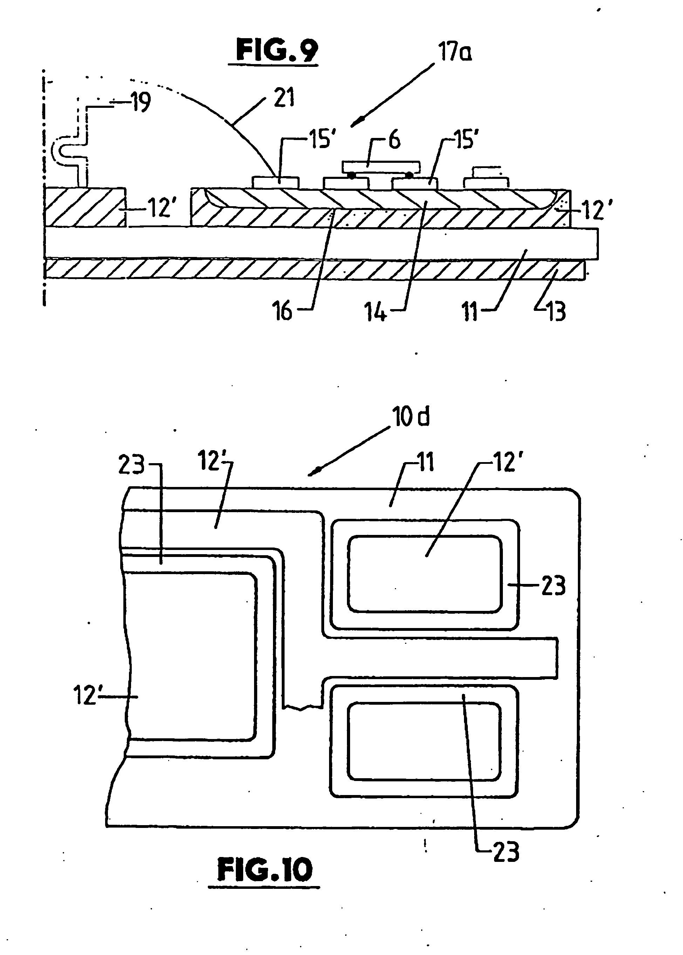

Anstelle des Substrates 10a kann bei einem Leistungsmodul selbstverständlich auch ein anderes Metall-Keramik-Substrat gemäß der Erfindung verwendet werden, beispielsweise das Substrat 10b oder 10c, d.h. ein Substrat mit dem in den Figuren 5 und 6 dargestellten Aufbau. Die Figur 9 zeigt ein Modul 17a mit dem Substrat 10b.

Als Metall für die Metallschichten, insbesondere auch für die Metallschichten 12 und 13 eignet sich Kupfer, wobei dann die Metallschichten 12 und 13 unter Verwendung von Kupferfolien und unter Anwendung der DCB-Technik (Direct-Copper-Bonding-Technik) hergestellt werden. Die Verwendung auch anderer Metalle ist grundsätzlich möglich.

Als Keramik eignet sich für die Keramikschicht 11 beispielsweise eine Aluminiumoxid-Keramik (Al₂O₃). Grundsätzlich sind auch andere Keramiken denkbar, beispielsweise AlN, BeO, CBN, Si₃N₄ und SiC.

Bei dem vorstehend in Zusammenhang mit der Figur 3 beschriebenen Verfahren wurde davon ausgegangen, dass die die Metallschicht bildende Metall- oder Leitpaste (Dickfilmpaste) entweder unstrukturiert aufgebracht und eingebrannt wird, worauf dann anschließend eine Strukturierung zur Erzeugung der Bereiche 15' durch eine geeignete Technik, beispielsweise durch eine Maskierungs- und Ätztechnik erfolgt, oder aber dass die Leitpaste bereits in der gewünschten Strukturierung aufgebracht und eingebrannt wird. Es besteht weiterhin die auch Möglichkeit, dass eine fotoempfindliche Leitpaste verwendet wird, d.h. eine Leitpaste, die nach dem Aufbringen und vor dem Einbrennen entsprechend der gewünschten Struktur belichtet wird, wobei dann z.B. die nicht belichteten Bereich beispielsweise in einem anschließenden Verfahrensschritt ("Entwicklungsverfahrens") entfernt werden, so dass eine sehr feine Strukturierung vor dem Einbrennen der Leitpaste erreicht ist. Die fotoempfindliche Leitpaste kann auch so ausgebildet sein, dass nach dem Belichten die belichteten Bereiche entfernt werden können.

Ein Verfahren zum Herstellen des Metall-Keramik-Substrates hätte dann bei Verwendung der fotoempfindliche Leitpaste die nachstehend aufgeführten Verfahrensschritte:
a) Zur Bildung der Metallschichten 12 und 13 werden mittels des DCB-Prozesses wenigstens zwei an ihren Oberflächenseiten oxidierte Zuschnitte einer Kupferfolie jeweils auf eine Oberflächenseite der Keramikschicht 11 aufgebracht. Vor dem Aufbringen werden die Kupferfolienzuschnitte vorzugsweise in einem vorausgehenden Verfahrensschritt in einer Schutzgasatmosphäre, beispielsweise in einer Stickstoffatmosphäre getempert, und zwar zur Reduzierung der Härte des Kupfermaterials.
b) Nach dem Abkühlen wird auf die Metallschicht 12 beispielsweise durch Aufdrucken oder mit einem anderen, geeigneten Verfahren eine die spätere Isolierschicht 14 bildende Schicht aus einer glashaltigen Paste aufgebracht.
c) Die Paste wird getrocknet und dann bei einer Temperatur, die unter der Temperatur des DCB-Prozesses liegt, d.h. beispielsweise bei einer Temperatur im Bereich zwischen 750 und 1030°C eingebrannt, so dass die Paste dann die auf der Metallschicht 12 haftende Isolierschicht 14 bildet.
d1) Anschließend wird eine Schicht aus der fotoempfindlichen Leitpaste aufgetragen und diese Schicht entsprechend der gewünschten Strukturierung belichtet.
d2) In einem anschließenden Verfahrensschritt werden die belichteten oder nicht belichteten Bereiche der von der Paste gebildeten Schicht entfernt.
e) Die strukturierte Leitpaste (Dickfilm) wird dann bei einer Temperatur im Bereich zwischen 750 bis 1030°C eingebrannt.

Das Strukturieren der Metallschicht 12 erfolgt bei diesem Verfahren beispielsweise vor dem Aufbringen der Isolierschicht 14, d.h. anschließend an den obigen Verfahrensschritt a).

Die Figur 10 zeigt in vereinfachter Teildarstellung und in Draufsicht ein Metall-Keramik-Substrat 10d mit den von der Metallschicht 12 gebildeten strukturierten Bereichen 12'. Einige Bereiche 12' sind bei der dargestellten Ausführungsform jeweils an ihrem Rand mit einem rahmenartigen Lotstoppauftrag 23 versehen, der von einer auf die frei liegende Oberseite der Bereiche 12' aufgebrachten Schicht aus der glashaltigen Paste, z.B. "Dietectric Composition 4575D" gebildet ist, die vorstehend für die Isolierschicht 14 verwendet wurde. Es hat sich gezeigt, dass durch diesen Auftrag 23 ein optimal wirkender Lotstop erreicht wird, d.h. es ist wirksam verhindert, dass bei Auflöten von Bauelementen, Anschlüssen usw. auf die mit dem Lotstopauftrag 23 versehenen Bereiche Lot über diesen Lotstop an angrenzende Bereiche 12' fließt und dadurch unerwünschte elektrische Verbindungen erzeugt. Jeder Lotstopauftrag 23 umschließt dabei denjenigen Teil des strukturierten Bereichs 12', auf den (Teil) später Lot aufgebracht wird. Durch das verwendete Material (glashaltige Paste) besitzt der jeweilige Lotstopauftrag 23 eine hohe Temperaturfestigkeit, was wiederum dazu beiträgt, dass Lotmaterialien mit hoher Verarbeitungstempertur verwendet werden können, insbesondere auch bleifreie Lotmaterialien.

Die Herstellung des Substrates 10d erfolgt in der Weise, dass nach dem Aufbringen der Metallschicht 12 und ggfs. auch der Metallschicht 13 (sofern vorhanden) auf die Keramikschicht 11 mittels der Direct-Bonding-Technik und nach dem Strukturieren der Metallschicht 12 der Auftrag der glashaltigen Paste entsprechend dem gewünschten Verlauf des jeweiligen Lotstopauftrags 23 auf Bereiche 12' erfolgt, und zwar mit einer Dicke von etwa 0,015-0,15 mm. Nach dem Trockenen der Paste wird diese bei einer Temperatur zwischen 750 und 1030°C eingebrannt.

Wird auf dem Substrat 10d wenigstens eine Isolierschicht 14 aufgebracht, so erfolgt das Aufbringen, Trocknen und Einbrennen der glashaltigen Paste für die Isolierschicht 14 und den jeweiligen Lotstopauftrag 23 in gemeinsamen Arbeitsschritten.

Die Erfindung wurde voranstehend an Ausführungsbeispielen beschrieben. Es versteht sich, dass zahlreiche Änderungen sowie Abwandlungen möglich sind, ohne dass dadurch der die Erfindung tragende Gedanke verlassen wird.

### Bezugszeichenliste

- 1, 1a: Halbleiterleistungsmodul entsprechend dem Stand der Technik
- 2: Metall-Keramik-Substrat
- 3, 4: Halbleiterleistungsbauelemente
- 5: zusätzliche Leiterplatte
- 6: Bauelemente einer Ansteuer- oder Treiberstufe
- 7: Grundplatte
- 10, 10a, 10b: Metall-Keramik-Substrat gemäß der Erfindung
- 10c, 10d: Metall-Keramik-Substrat gemäß der Erfindung
- 11: Keramikschicht
- 12, 13: Metallschicht
- 12': strukturierter Bereich
- 14, 14c: Isolierschicht
- 15, 15c: weitere Metallschicht
- 15': strukturierter Bereich
- 16: Vertiefung
- 17, 17a: Leistungsmodul gemäß der Erfindung
- 18: interne Verbindung
- 19: äußerer Leistungsanschluß
- 20, 21: interne Verbindung
- 22: Grundplatte
- 23: Lotstopauftrag

## Patentansprüche

1. Metall-Keramlk-Substrat für elektrische Schaltkreise oder Module, mit wenigstens einer Isolierschicht und mit wenigstens einer auf einer Oberflächenseite der Isolierschicht flächig aufgebrachten. Metallschicht (12), die zur Bildung von Leiterbahnen, Kontaktflächen, Montageflächen usw. strukturiert ist, wobei auf wenigstens einen strukturierten Bereich (12').der Metallschicht (12) ein Lötsbopauftrag (23) aus einem glashaltigen Material vorgesehen ist,
**dadurch gekennzeichnet**
**dass** die Isolierschicht eine Keramikschicht ist dass die Metallschicht (12) eine Dicke im Bereich zwischen 0,1 mm bis 0,9 mm aufweist, dass die Metallschicht (12) mit Hilfe des Direct Bondina Verfahrens auf die Keramikschicht (11) aufgebracht is und dass der Lötstopauftrag (23) eine Dicke von etwa 0,015 mm bis 0,15 mm aufweist.

2. Metall-Keramik-Substrat nach Anspruch 1, **dadurch gekennzeichnet, dass** das Metall der wenigstens einen Metallschicht (12) Kupfer ist.

## Claims

1. Metal-ceramic substrate for electrical circuits or modules, having at least one insulation layer and at least one metal layer (12) which is applied flat to a surface side of the insulation layer and is structured to form conductor paths, contact surfaces, assembly surfaces etc, wherein a solder stop barrier layer (23) of a glass-containing material is provided on at least one structured region (12') of the metal layer (12), **characterised in that** the insulation layer is a ceramic layer, that the metal layer (12) has a thickness in the range between 0.1 mm and 0.9 mm, that the metal layer (12) is applied to the ceramic layer (11) by means of the direct bonding process, and that the solder stop barrier layer (23) has a thickness of about 0.015 mm to 0.15 mm.

2. Metal-ceramic substrate according to claim 1 **characterised in that** the metal of the at least one metal layer (12) is copper.

## Revendications

1. Substrat de métal-céramique pour un circuit électrique ou des modules électriques, avec au moins une couche isolante et avec au moins une couche de métal (12) appliquée à plat sur un côté de la surface de la couche isolante, qui est structurée pour former des pistes conductrices, des surfaces de contact, des surfaces de montage, etc., dans lequel sur au moins une zone structurée (12') de la couche de métal (12), il est prévu un enduit d'arrêt de brasage (23) constitué d'un matériau contenant du verre,
**caractérisé en ce que**
la couche isolante est une couche de céramique, **en ce que** la couche de métal (12) présente une épaisseur dans la plage comprise entre 0,1 mm et 0,9 mm, **en ce que** la couche de métal (12) est appliquée sur la couche de céramique (11) à l'aide du procédé de collage direct et **en ce que** l'enduit d'arrêt de brasage (23) présente une épaisseur d'environ 0,015 mm à 0,15 mm.

2. Substrat de métal-céramique selon la revendication 1, **caractérisé en ce que** le métal de la au moins une couche de métal (12) est le cuivre.
